# EUROPÄISCHE PATENTSCHRIFT

(11) **EP 0 578 007 B1**
(45) Veröffentlichungstag und Bekanntmachung des Hinweises auf die Patenterteilung: **15.09.1999**
(21) Anmeldenummer: 93109501.2
(22) Anmeldetag: 15.06.1993
(51) Int. Cl.: H04B 1/10, H03J 1/00

(54) **Schaltungsanordnung zur Erkennung und Unterdrückung von Nachbarkanalstörungen**
Circuit arrangement for the recognition and suppression of adjacent channel interference
Circuit pour détecter et supprimer l'interférence des canaux adjacents

(30) Priorität: 08.07.1992 DE 4222309
(43) Veröffentlichungstag der Anmeldung: 12.01.1994
(73) Patentinhaber: Blaupunkt-Werke GmbH, 31132 Hildesheim (DE)
(72) Erfinder: Schwarz, Detlef, D-3000 Hannover 91 (DE)

(56) Entgegenhaltungen:
- EP-A- 0 443 170
- DE-A- 2 812 954
- GB-A- 2 003 685

## Beschreibung

Die Erfindung geht aus von einer Schaltungsanordnung nach der Gattung des Hauptanspruchs.

Derartige Schaltungsanordnungen dienen zur Unterdrückung von Störungen, die von Sendern in Nachbarkanälen verursacht werden, die beispielsweie infolge von Überreichweiten oder großen Frequenzhüben die Wiedergabequalität des jeweils empfangenen Senders beeinträchtigen. Um die veränderbare ZF-Filteranordnung steuern zu können, ist die Erkennung von Nachbarkanalstörungen erforderlich.

Weiterhin sind aus der EP-A-0 443 170 ein Verfahren und eine Vorrichtung zur ZF-Bandbreitenumschaltung in einem AMRundfunkempfänger zur Anpassung an ein empfangenes AM-Rundfunksignal beschrieben. Eine derartige Bandbreitenumschaltung ist für den Fall zweckmäßig, daß neben Rundfunksendern mit normaler Modulationsbandbreite auch solche mit zum Zweck verbesserter Klangqualität erhöhter Bandbreite ausgestrahlt werden. Im Sinne einer Optimierung des Rundfunkempfangs wird dabei die Bandbreitenumschaltung in Abhängigkeit einer neben dem eigentlichen Programminhalt übertragenen, die Modulationsbandbreite des Programms anzeigenden Kennung und darüber hinaus gegebenenfalls in Abhängigkeit der Empfangsverhältnisse vorgenommen. Zur Beurteilung der Empfangsverhältnisse wird dabei unter anderem auch das Vorhandensein von Nachbarkanalstörungen ausgewertet.

Die beschriebene Anordnung umfaßt dazu einen aus einer Diode und einem der Diode parallel geschalteten Serienschwingkreis bestehenden Nachbarkanal-Störauswerter, dem über einen Demodulationshilfskreis das grob gefilterte ZF-Signal zugeführt ist. Der Serienschwingkreis, dem das AM-demodulierte ZF-Signal zugeführt ist, ist auf das AMKanalraster von in Europa 9 kHz abgestimmt. Für den Fall, daß sich aufgrund der Ausbreitungsbedingungen beim AM-Empfang beim eingestellten Sender und dem im Kanalraster benachbarten Sender ein etwa gleicher Empfangspegel einstellt, überlagern sich bei breiter Einstellung des ZF-Filters die Seitenbänder des empfangenen Senders mit dem Träger des Nachbarkanalsenders oder dessen Seitenbändern, was unangenehme Störungen zur Folge hat. In diesem Fall tritt am Gleichtrichter des Nachbarkanal-Störauswerters ein 9 kHzInterferenzton auf, der den Serienschwingkreis anregt, und dessen Amplitude, sofern sie einen vorgegebenen Schwellwert übersteigt, zur Umschaltung des ZF-Filters von einen breiten auf einen schmalen Durchlaßbereich herangezogen wird.

Der Erfindung liegt die Aufgabe zugrunde, eine Schaltungsanordnung zur Unterdrückung von Nachbarkanalstörungen derart auszubilden, daß eine Erkennung von Nachbarkanalstörungen mit geringem schaltungstechnischen Aufwand möglich ist.

Diese Aufgabe wird erfindungsgemäß durch die im Patentanspruch 1 angegebenen Maßnahmen gelöst. Insbesondere hat die erfindungsgemäße Schaltungsanordnung den Vorteil, daß bei Vorhandensein eines Kurzwellenempfangsteils für das 31m-Band der zusätzliche Aufwand äußerst gering ist.

Durch die in den Unteransprüchen aufgeführten Maßnahmen sind vorteilhafte Weiterbildungen und Verbesserungen der im Hauptanspruch angegebenen Erfindung möglich. Dabei ist insbesondere durch die Verwendung eines Mikrocomputers, der auch andere Funktionen im Gerät steuert, in Verbindung mit einem Pegelmeßausgang des Kurzwellenempfangsteils praktisch kein zusätzlicher Schaltungsaufwand zur Erkennung der Nachbarkanalstörungen erforderlich.

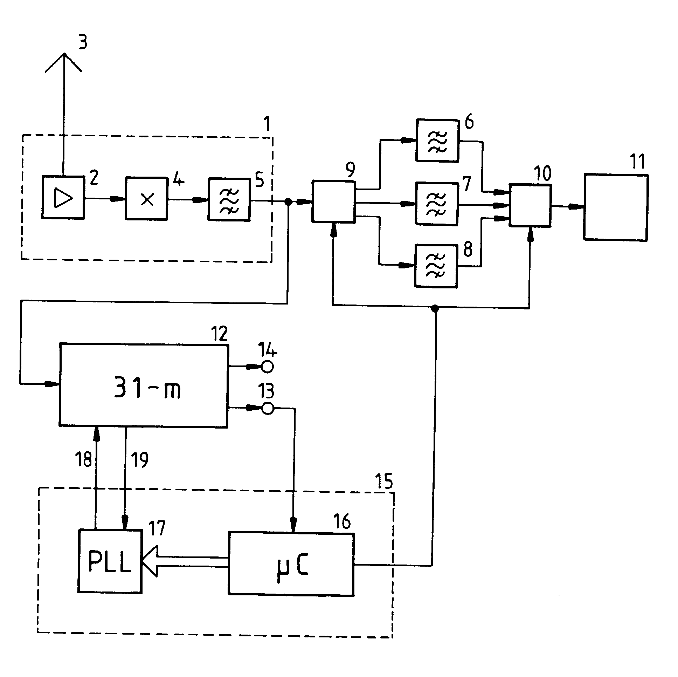

Ein Ausführungsbeispiel der Erfindung ist in der Zeichnung dargestellt und in der nachfolgenden Beschreibung näher erläutert. Die Zeichnung zeigt die wesentlichen Teile eines Empfängers mit einer erfindungsgemäßen Schaltungsanordnung und mit einem Mikrocomputer, der unter anderem die Abstimmung des Kurzwellenempfangsteils steuert und die gemessenen Pegel auswertet.

Das UKW-Empfangsteil 1 des dargestellten Rundfunkempfängers besteht in an sich bekannter Weise aus einer Vorstufe 2, der von einer Antenne 3 die zu empfangenden Signale zugeführt werden, einem Mischer 4 und einem breitbandigen ZF-Filter 5, dessen Bandbreite etwa ±250kHz beträgt. Im weiteren ZF-Signalweg befindet sich eine steuerbare Filteranordnung, die aus drei Filtern 6, 7, 8 mit unterschiedlicher Bandbreite und zwei Umschaltern 9, 10 besteht. Die Umschalter 9, 10 sind gemeinsam derart steuerbar, daß jeweils eines der Filter 6, 7, 8 in den ZF-Signalweg eingeschaltet wird. An den Ausgang des Umschalters 10 sind wie bei bekannten Rundfunkempfängern ein Demodulator, ein Stereodecoder, ein NF-Teil und Lautsprecher angeschlossen, die in der Zeichnung lediglich durch einen Block 11 symbolisiert sind.

Zur Erkennung von Nachbarkanalstörungen wird das Ausgangssignal des ZF-Filters 5 dem Eingang eines Kurzwellenempfangsteils 12 für das 31m-Band zugeführt, dessen Empfangsbereich auf ein Frequenzband von 10MHz bis 11MHz erweitert ist. Derartige Empfangsteile sind in Rundfunkempfängern mit Kurzwellenempfangsteil meist vorhanden und weisen häufig auch einen Ausgang 13 auf, in welchem eine von der Empfangsfeldstärke bzw. vom empfangenen Pegel abhängige Spannung ansteht. Der NF-Ausgang 14 des Kurzwellenempfangsteils 12 wird beim Betrieb zur Erkennung der Nachbarkanalstörungen nicht benutzt. Zur Steuerung verschiedener Funktionen umfaßt der dargestellte Empfänger eine Steuereinrichtung 15, die unter anderem einen Mikrocomputer 16 und eine PLL-Schaltung 17 mit einem vom Mikrocomputer steuerbaren Synthesizer enthält, mit welcher aus entsprechenden Signalen des Mikrocomputers eine Abstimmspannung für den Kurzwellenempfangsteil 12 erzeugt wird. Die PLL-Schaltung 17 ist über Leitungen 18, 19 für die Abstimmspannung und das Ausgangssignal des Oszillators mit dem Kurzwellenempfangsteil 12 verbunden.

Einem Eingang des Mikrocomputers 16 wird außerdem die den Empfangspegel des Kurzwellenempfangsteils darstellende Spannung vom Ausgang 13 zugeführt. Ein weiterer Ausgang des Mikrocomputers ist mit Steuereingängen der Umschalter 9, 10 verbunden.

Zur Ermittlung von Nachbarkanalstörungen steuert der Mikrocomputer über die PLL-Schaltung 17 das Kurzwellenempfangsteil zyklisch auf verschiedene Frequenzen innerhalb des Durchlaßbereichs des ZF-Filters 5, beispielsweise auf 10,7MHz, 10,7MHz±100kHz und 10,7MHz±200kHz. Neben anderen Programmen ist im Mikrocomputer 16 ein Programm vorgesehen, das den bei 10,7MHz gemessenen Pegel speichert und die bei den Nachbarkanälen gemessenen Pegel mit dem gespeicherten Pegel vergleicht.

Ergibt sich bei einer der außerhalb der Mittenfrequenz von 10,7MHz liegenden Empfangsfrequenzen ein verhältnismäßig großer Pegel, kann hieraus auf das Vorhandensein einer Nachbarkanalstörung geschlossen werden. Je nachdem, in welchem Frequenzabstand dieser große Pegel auftritt, kann durch Einschalten eines der Filter 6, 7, 8 die Nachbarkanalstörung unterdrückt werden. Liegt keine Nachbarkanalstörung mehr vor, so kann dasjenige Filter 6, 7, 8 eingeschaltet werden, das eine optimale Wiedergabe eines ungestörten Empfangssignals ermöglicht.

Die Erfindung kann auch ohne Mikrocomputer verwirklicht werden, wobei die Abstimmspannung des Kurzwellenempfangsteils mit Hilfe einer geeigneten Schaltung zyklisch auf mehrere Festwerte gesetzt wird. Die Pegel am Ausgang 13 des Kurzwellenempfangsteils können mit einer Auswerteschaltung zur Erzeugung eines Steuersignals für die Umschalter 6 bis 8 verglichen werden.

Die Erfindung kann ferner auch bei einem Empfänger mit zwei UKW-Empfangsteilen angewendet werden. Dabei kann die PLL-Schaltung des zweiten UKW-Empfangsteils auch das Kurzwellenempfangsteil steuern.

## Patentansprüche

1. Schaltungsanordnung zur Erkennung und Unterdrückung von Nachbarkanalstörungen in einem Rundfunkempfänger, insbesondere in einem UKW-Empfänger, wobei im ZF-Signalweg ein breitbandiges ZFFilter (5) und eine bezüglich ihrer Bandbreite in Abhängigkeit von einer erkannten Nachbarkanalstörung steuerbare ZF-Filteranordnung (6 bis 10) vorgesehen sind, wobei das Ausgangssignal des breitbandigen ZF-Filters (5) einem im Rundfunkempfänger vorhandenen Kurzwellenempfangsteil (12) zugeführt wird, wobei das Kurzwellenempfangsteil (12) von einer Steuereinrichtung (15) zyklisch auf mehrere auf den Durchlaßbereich des breitbandigen ZF-Filters (5) verteilte Frequenzen abgestimmt wird, wobei bei jeder abgestimmten Frequenz der Pegel des vom Kurzwellenempfangsteil (12) empfangenen Signals gemessen wird, und wobei in Abhängigkeit der gemessenen Pegel die ZF-Filteranordnung (6 bis 10) gesteuert wird.

2. Schaltungsanordnung nach Anspruch 1, dadurch gekennzeichnet, daß als Kurzwellenempfangsteil (12) ein im Rundfunkempfänger ohnehin vorhandener Kurzwellenempfangsteil dient, bei welchem das 31m-Band auf Empfangsfrequenzen zwischen 10 MHz und 11 MHz erweitert ist.

3. Schaltungsanordnung nach Anspruch 1, dadurch gekennzeichnet, daß aus den beim zyklischen Abstimmen erhaltenen Pegelwerten Differenzen gebildet werden.

4. Schaltungsanordnung nach Anspruch 1, dadurch gekennzeichnet, daß das Kurzwellenempfangsteil (12) auf 10,7 MHz, 10,7Mhz ± 100kHz und 10,7Mhz ± 200kHz abgestimmt wird.

5. Schaltungsanordnung nach Anspruch 1, dadurch gekennzeichnet, daß die Steuereinrichtung (15) einen Mikrocomputer (16) enthält, der mit Hilfe einer PLL-Schaltung (17) zyklisch verschiedenen Abstimmfrequenzen entsprechende Abstimmspannungen für das Kurzwellenempfangsteil (12) erzeugt und ein den jeweils empfangenen Pegel beschreibendes Signal des Kurzwellenempfangsteils (12) auswertet.

## Claims

1. Circuit arrangement for the recognition and suppression of adjacent channel interference in a radio receiver, in particular in a VHF receiver, a broadband IF filter (5) and an IF filter arrangement (6 to 10), which can be controlled with regard to its bandwidth in dependence on adjacent channel interference that has been recognized, being provided in the IF signal path, the output signal of the broadband IF filter (5) being fed to a short-wave reception part (12) present in the radio receiver, the short-wave reception part (12) being tuned cyclically by a control device (15) to a plurality of frequencies distributed within the passband of the broadband IF filter (5), the level of the signal received by the short-wave reception part (12) being measured for each tuned frequency, and the IF filter arrangement (6 to 10) being controlled in dependence on the measured levels.

2. Circuit arrangement according to Claim 1, characterized in that the short-wave reception part (12) that is used is a short-wave reception part which is present in any case in the radio receiver and in which the 31m band is extended to reception frequencies between 10 MHz and 11 MHz.

3. Circuit arrangement according to Claim 1, characterized in that differences are formed from the level values obtained during the cyclic tuning.

4. Circuit arrangement according to Claim 1, characterized in that the short-wave reception part (12) is tuned to 10.7 MHz, 10.7 MHz ± 100 kHz and 10.7 MHz ± 200 kHz.

5. Circuit arrangement according to Claim 1, characterized in that the control device (15) contains a microcomputer (16), which, with the aid of a PLL circuit (17), cyclically generates tuning voltages for the short-wave reception part (12), the said tuning voltages corresponding to different tuning frequencies, and evaluates a signal of the short-wave reception part (12) that describes the respectively received level.

## Revendications

1. Circuit pour détecter et supprimer des interférences entre canaux voisins dans des récepteurs de radiodiffusion, notamment un récepteur MF, dans lequel,
- le chemin du signal FI comporte un filtre FI (5) de bande large et un circuit de filtre FI (6-10) dont la largeur de bande se commande en fonction des interférences entre canaux voisins détectées,
- le signal de sortie du filtre FI en bande large (5) est appliqué à un récepteur ondes courtes (12) prévu dans le récepteur de radiodiffusion,
- le récepteur ondes courtes (12) est accordé cycliquement par une installation de commande (15) sur plusieurs fréquences réparties dans la plage passante du filtre FI, (5) à bande large,
- à chaque fréquence accordée, on mesure le niveau du signal reçu par le récepteur ondes courtes (12) et,
- en fonction du niveau mesuré, on commande l'association des filtres FI (6-10).

2. Circuit selon la revendication 1,
caractérisé en ce que
comme récepteur ondes courtes (12) on utilise la partie réception d'ondes courtes existant de toute façon dans le récepteur de radiodiffusion, pour lequel la bande (31m) est étendue à des fréquences de réception comprises entre 10 MHz et 11 MHz.

3. Circuit selon la revendication 1,
caractérisé en ce qu'
on forme les différences des valeurs des niveaux obtenus pour les accords cycliques.

4. Circuit selon la revendication 1,
caractérisé en ce que
le récepteur d'ondes courtes (12) est accordé sur 10,7 MHz, 10,7 MHz ± 100 kHz et 10,7 MHz ± 200 kHz.

5. Circuit selon la revendication 1,
caractérisé en ce que
l'installation de commande (15) comporte un microordinateur (16) qui à l'aide d'un circuit PLL (17) génère cycliquement des tensions d'accord correspondant à différentes fréquences d'accord pour le récepteur d'ondes courtes (12) et il exploite un signal du récepteur d'ondes courtes (12) qui décrit le niveau respectivement reçu.
